# EUROPÄISCHE PATENTSCHRIFT

(11) **EP 2 218 101 B1**
(45) Veröffentlichungstag und Bekanntmachung des Hinweises auf die Patenterteilung: **14.02.2018**
(21) Anmeldenummer: 08856359.8
(22) Anmeldetag: 04.12.2008
(51) Int. Cl.: H01L 23/14, H01L 23/15

(54) **SILIZIUM-KERAMIK-VERBUNDSUBSTRAT UND DESSEN HERSTELLUNG**
SILICON-CERAMIC COMPOSITE SUBSTRATE AND ITS MANUFACTURE
SILICON-CERAMIC COMPOSITE SUBSTRATE ET SA FABRICATION

(30) Priorität: 06.12.2007 DE 102007059609
(43) Veröffentlichungstag der Anmeldung: 18.08.2010
(73) Patentinhaber: Technische Universität Ilmenau, 98693 Ilmenau (DE); Fraunhofer-Gesellschaft zur Förderung der angewandten Forschung e.V., 80686 München (DE)
(72) Erfinder: FISCHER, Michael, 07407 Uhlstädt-Kirchhasel (DE); BARTSCH DE TORRES, Heike, 98693 Ilmenau (DE); HOFFMANN, Martin, 98704 Langewiesen (DE); MÜLLER, Jens, 98693 Ilmenau (DE); PAWLOWSKI, Beate, 07743 Jena (DE); BARTH, Stefan, 07749 Jena (DE)
(74) Vertreter: Engel, Christoph Klaus
(86) Internationale Anmeldenummer: PCT/EP2008/066837
(87) Internationale Veröffentlichungsnummer: WO 2009/071645

(56) Entgegenhaltungen:
- DE-A1- 19 818 060
- JP-A- 2006 133 245
- GESSNER (ED): "Smart Systems Integration 2007" 28. März 2007 (2007-03-28), VDE VERLAG , PARIS , XP008109494 in der Anmeldung erwähnt Seite 477 - Seite 479
- STUBENRAUCH M ET AL: "Black silicon-new functionalities in microsystems; Black silicon---new functionalities in microsystems" JOURNAL OF MICROMECHANICS & MICROENGINEERING, INSTITUTE OF PHYSICS PUBLISHING, BRISTOL, GB, Bd. 16, Nr. 6, 1. Juni 2006 (2006-06-01), Seiten S82-S87, XP020105022 ISSN: 0960-1317
- DATABASE INSPEC [Online] THE INSTITUTION OF ELECTRICAL ENGINEERS, STEVENAGE, GB; June 2006 (2006-06), RUSU C ET AL: "LTCC interconnects in microsystems", Database accession no. 9024353
- E Müller ET AL: "Development and Processing of an Anodic Bondable LTCC Tape", Proc. 15th European Microel. and Pack. Conf., 1 January 2005 (2005-01-01), pages 313-318, XP055191867, Brugge
- Wolfgang Brode ET AL: "Mikrostrukturierte und anodisch bondbare Glaskeramikfolien für optische und sensorische Anwendungen - MABOGOS", , 1 January 2004 (2004-01-01), XP055191888, Hermsdorf/Jena DOI: 10.2314/GBV:485128950 Retrieved from the Internet: URL:https://getinfo.de/app/download?id=TIB KAT%3a485128950&cluster=tib&tib=zbwkat&tib =roempp&tib=blcp&tib=dkf&tib=sudoc&tib=tem a&tib=ceaba&tib=zbmkm&tib=ntis&tib=rdat&ti b=tibkat&tib=citeseerx&tib=blse&tib=kmo3d& tib=iud&tib=zbmql&tib=kmoav&tib=zmat&tib=e tde&tib=temaext&tib=rswb&tib=insp&tib=dkfl &tib=prob& [retrieved on 2015-05-28]

## Beschreibung

Die vorliegende Erfindung betrifft ein Verbundsubstrat aus Silizium und Keramik gemäß dem Oberbegriff des Anspruchs 1.

Die Integration von Halbleiterchips auf einem Keramik-Trägersubstrat, das eine Verdrahtungsstruktur und passive elektronische Bauelemente besitzen kann und zur elektrischen Verbindung eines Gesamtsystems dient, ist ein etabliertes Verfahren. Der Verbund zwischen dem fertigen Halbleiterchip und dem Keramik-Träger wird üblicherweise mittels Verbindungsverfahren wie Flip-Chip-Bonden, verschiedenen Löttechniken oder Klebeverfahren mit anschließendem Drahtbonden zur Erzeugung der elektrischen Verbindung realisiert. Diese Verbindungstechniken arbeiten jedoch immer mit zusätzlichen Hilfsstoffen wie Metallisierungen, Loten oder speziellen Klebstoffen und verursachen in der Regel einen hohen Justier- und Montageaufwand.

Es ist auch bekannt, Mehrlagenschaltungen auf der Basis von gesinterten Keramikträgern mit Niedertemperatur-Einbrandkeramiken (LTCC) herzustellen. Es können dabei Leiterbahnen, Kondensatoren, Widerstände, Spulen oder auch Fluidkanäle erzeugt werden. Die Elemente können durch Siebdruck oder photochemische Prozesse aufgebracht werden. Die ungebrannten Keramikfolien werden einzeln strukturiert, danach gestapelt und laminiert. Abschließend wird ein definiertes Sinterprofil mit einer Spitzentemperatur von ca. 850 - 900 °C gefahren.

Ein neueres Verfahren wird in [C. Rusu et. al, LTCC interconnects in microsystems, Journal of Micromechanics and Microengineering, 16 (2006), Seite 13-18] experimentell vorgestellt.

Es beschreibt zunächst die Möglichkeit, durch Anodisches Bonden eine LTCC-Keramik mit Silizium zu verbinden. Unter anderem wird die Verbindung eines 2x2 cm² großen Keramiksubstrates mit einem Silizium-Wafer durch Anodisches Bonden vorgestellt. Dabei wird eine spezielle Niedertemperaturkeramik (Low Temperature Cofired Ceramics - LTCC) verwendet, die durch ihre Zusammensetzung und einen mittleren bis geringen thermischen Ausdehnungskoeffizienten das Anodische Bonden der Keramik auf Silizium erlaubt. Jedoch muss diese zunächst gebrannte Niedertemperaturkeramik durch weitere, aufwendige Prozessschritte, wie Schleifen und Polieren, für das Bondverfahren vorbereitet werden. Außerdem ist zusätzlich ein Gerät zum Anodischen Bonden erforderlich. Bereits kleine Störungen der Oberfläche oder abgelagerte Partikel führen zu Gaseinschlüssen, welche die Haltbarkeit der Verbindung negativ beeinflussen.

Ein einfacher Silizium-Keramik-Verbund kann durch Laminieren und Sintern der Verbundpartner erzeugt werden [M. Fischer et. al, Bonding of ceramic and silicon - new options and applications, Smart Systems Integration, 2007], indem zunächst die ungebrannte Keramik auf eine nanostrukturierte Siliziumoberfläche auflaminiert wird. Anschließend erfolgt der Sinterprozess. Dadurch entfällt das aufwendige Polieren der Keramik. Ein anodisches Bondverfahren wird auch hier beschrieben: "Development and Processing of an Anodic Bondable LTCC Tape", von E. Müller et al. , Proc. 15th European Microel. and Pack. Conf., Seiten 313-318, Brugge
Aufgabe der vorliegenden Erfindung ist es, ein Silizium-Keramik-Verbundsubstrat mit hoher mechanischer Festigkeit und variabler Funktionalität bereitzustellen, welches preiswert und hilfsstofffrei herstellbar ist und mit der bekannten Standard-Halbleiterprozesstechnik weiterverarbeitet werden kann.

Erfindungsgemäß gelingt die Lösung dieser Aufgabe durch ein Silizium-Keramik-Verbundsubstrat mit den Merkmalen nach Patentanspruch 1 oder 10.

Das erfindungsgemäße Silizium-Keramik-Verbundsubstrat umfasst eine Niedertemperaturkeramik mit mindestens einer vorstrukturierten Keramiklage und ein Silizium-Substrat. Die Oberfläche des Silizium-Substrates weist in einem Kontaktbereich mit der Niedertemperaturkeramik Nanostrukturen auf, welche vollständig in die Niedertemperaturkeramik eingedrungen sind. Die Niedertemperaturkeramik bildet eine Trägerschicht für das Silizium-Substrat, welches mittels bekannter Halbleitertechnologien bearbeitet werden kann.

Vorzugsweise sind die Nanostrukturen aus dem so genannten "Black-Silicon" gebildet, welches nadelartige Spitzen aufweist.

Es ist aber ebenso möglich und vom Erfindungsgedanken mit umfasst, in dem Kontaktbereich andere Nanostrukturen vorzusehen, welche beispielsweise durch Polieren, Ätzen oder anderweitige Bearbeitung der Silizium-Substrat-Oberfläche erzeugt werden können.

Das thermische Ausdehnungsverhalten der Niedertemperaturkeramik ist vorteilhafterweise an das Ausdehnungsverhalten des Silizium-Substrates angepasst, sodass Stress an der Verbindungsstelle minimiert wird.

Zur Herstellung des erfindungsgemäßen Silizium-Keramik-Verbundsubstrates werden zunächst ungebrannte Keramikfolien ein- oder mehrlagig vorstrukturiert, d. h. mit Leiterbahnen, Vias (Durchkontaktierungen), Fluidkanälen oder auch mit Widerständen, Kondensatoren und/oder Spulen versehen. Das Vorstrukturieren erfolgt mit Hilfe von Standardverfahren, wie beispielsweise Stanzen, Via-Füllen, Siebdrucken oder Laserbearbeitung. Die Keramikfolien werden anschließend zur Herstellung der gewünschten Funktionalität und zur Herstellung einer Trägerschicht gestapelt.

Auf das Silizium-Substrat wird eine Nanostruktur aufgebracht. Anschließend wird das Silizium-Substrat auf die Trägerschicht unter der Einwirkung von Temperatur und Druck auflaminiert und der so entstandene Verbund gesintert.

Da sich der verwendete Bindungsmechanismus vom Anodischen Bonden unterscheidet, kann vorteilhafterweise auf die beim Anodischen Bonden erforderlichen natriumhaltigen Gläser in der Niedertemperaturkeramik verzichtet und ein halbleiterprozesskompatibles Verbundsubstrat erzeugt werden, das die Basis für verschiedene MEMS (Micro-Electro-Mechanical System)-Anwendungen bildet.

Die Vorteile der Erfindung sind insbesondere darin zu sehen, dass ein Verbundsubstrat vorliegt, das sich durch seine hohe Multifunktionalität und hohe mechanische Festigkeit auszeichnet. Außerdem können mittels der abgewandelten LTCC-Technologie verschiedenartige Funktionalitäten in die Trägerschicht integriert werden.

Als besonders vorteilhaft hat es sich herausgestellt, dass auf den kompletten Arbeitsgang des Sinterns der LTCC-Keramik vorab verzichtet werden kann, da dieses integral mit der Herstellung des erfindungsgemäßen Silizium-Keramik-Verbundsubstrates erfolgt. Außerdem kann durch den Entfall des sonst vorab benötigten Sintervorganges der LTCC eine größere Vielfalt, an herstellbaren LTCC-Strukturen erreicht werden, da diese als Schichten von ungebrannten Keramikfolien nach Bedarf zusammengestellt werden können.

Weitere bevorzugte Ausführungsformen der Erfindung sind in den Unteransprüchen angegeben.

Weitere Einzelheiten und Vorteile der Erfindung sind dem nachfolgenden Beschreibungsteil zu entnehmen, in dem die Erfindung unter Bezugnahme auf die beigefügten Zeichnungen näher erläutert wird.

Es zeigen:
- Fig. 1: - eine schematische Darstellung der Verfahrensschritte zur Herstellung eines erfindungsgemäßen Silizium-Keramik-Verbundsubstrates;
- Fig. 2: - eine schematische Darstellung der Herstellung eines elektrischen Kontaktes in einem Silizium-KeramikVerbundsubstrat;
- Fig. 3: - eine schematische Darstellung zur Vereinzelung von Silizium-Chips auf einem Silizium-Keramik-Verbundsubstrat.

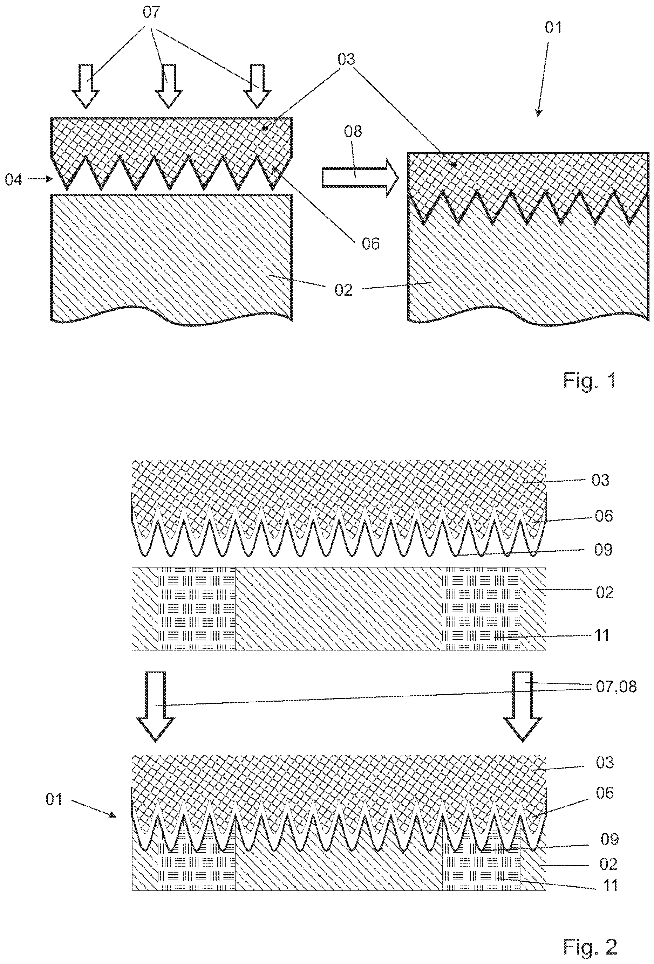

Fig. 1 zeigt eine schematische Darstellung der Verfahrensschritte zur Herstellung eines erfindungsgemäßen Silizium-Keramik-Verbundsubstrates 01.

Auf eine ungebrannte Niedertemperaturkeramik 02, die aus einer oder mehreren Keramiklagen besteht und schon eine Verdrahtungsstruktur mit Leiterbahnen, Durchkontaktierungen (Vias), Widerständen, Spulen, Kondensatoren und fluidischen Kanälen besitzen kann (nicht dargestellt), wird ein Silizium-Substrat 03, das in einem Kontaktbereich 04 eine Nanostruktur 06 aufweist, unter Einwirkung von Druck und Temperatur ohne Hinzufügen eines Hilfsstoffes auflaminiert. Das Silizium-Substrat 03 ist vorzugsweise ein Silizium-Wafer, welcher vollständig oder teilweise nanostrukturiert ist.

Die Nanostruktur 06 der Oberfläche des Silizium-Substrates 03 kann dabei beispielsweise durch einen selbstmaskierenden Plasmaätzprozess realisiert werden, wobei die geometrischen Abmessungen der dadurch erzeugten nadelartigen Nanostrukturen 06 vorzugsweise an die Pulvermorphologie der ungebrannten Niedertemperaturkeramik 02 (z.B. die Korngröße der Feststoffe der Rohkeramik) angepasst sind. Eine vorteilhafte Nadelstruktur, hat dabei Abstände der Nadeln, die im Bereich der Korngröße der Feststoffe der Rohkeramik liegen.

Das Laminieren erfolgt in einer Presse (angedeutet durch die Pfeile 07), beispielsweise bei Temperaturen zwischen 80°C und 120°C in einem Zeitraum von 1 bis zu 30 Minuten.

Anschließend wird vorzugsweise in einem Drucksinterprozess (angedeutet durch den Pfeil 08) bei maximalen Temperaturen bis zu 950°C das stoff- und/oder formschlüssige Silizium-Keramik-Verbundsubstrat 01 hergestellt.

Die nadelartigen Nanostrukturen 06 dringen beim Laminieren 07 vollständig in die Niedertemperaturkeramik 02 ein und bewirken so eine dichte Verbindung, die es z.B. erlaubt, in der Niedertemperaturkeramik vorhandene Fluidkanäle am Silizium entlang zu führen. Dies kann vorteilhafterweise zur Kühlung der später im Silizium erzeugten Struktur genutzt werden. Die so erzeugten Kühlkanäle wirken besonders effektiv auf das Silizium, aufgrund der durch die Nanostruktur 06 vergrößerten Oberfläche.

Fig. 2 zeigt eine schematische Darstellung einer bevorzugten Ausführungsform der Erfindung. Wird vor dem Laminieren eine Metallisierung 09 auf die Nadeln der Nanostruktur 06 aufgebracht, kann während des Sinterns ein elektrischer Verbund zwischen den auf der Niedertemperaturkeramik 02 vorhandenen Leiterbahnen (nicht dargestellt) oder metallischen Vias 11 und der auf dem Silizium-Substrat 03 befindlichen Metallisierung 09 hergestellt werden.

Das so entstandene Silizium-Keramik-Verbundsubstrat 01, das sich durch eine sehr hohe Festigkeit auszeichnet, besitzt vorzugsweise die Außenkontur eines Standard-Wafers (z.B. 4") und ist somit zu allen Anlagen und Geräten für eine sich anschließende Halbleiterprozessierung (Lithografie, Dünnschichttechniken, Plasmastrukturierungsverfahren etc.) kompatibel.

Wird das erfindungsgemäße Keramik-Silizium-Verbundsubstrat 01 auf die beschriebene Art und Weise hergestellt und weiterprozessiert, muss das Silizium-Substrat 03 selbst keine hohe mechanische Festigkeit aufweisen, da die Niedertemperaturkeramik 02 die Trägerfunktion während der sich anschließenden, technologischen Folgeschritte übernimmt. Das bedeutet, dass das Silizium-Substrat 03 nur so dick ausgeführt sein muss, dass die elektronischen Funktionen gewährleistet werden, was wiederum eine erhebliche Materialersparnis zur Folge hat. Außerdem kann die Prozesszeit beispielsweise beim Ätzen stark verkürzt werden, wenn die Silizium-Schicht nur eine Minimaldicke aufweist. Eine vorteilhafte Dicke des Silizium-Substrates 03 liegt etwa im Bereich von 50 bis 100 µm.

Ähnlich wie bei der SOI (Silicon On Insulator)-Technologie wird somit Silizium nur dort eingesetzt, wo es funktionell erforderlich ist.

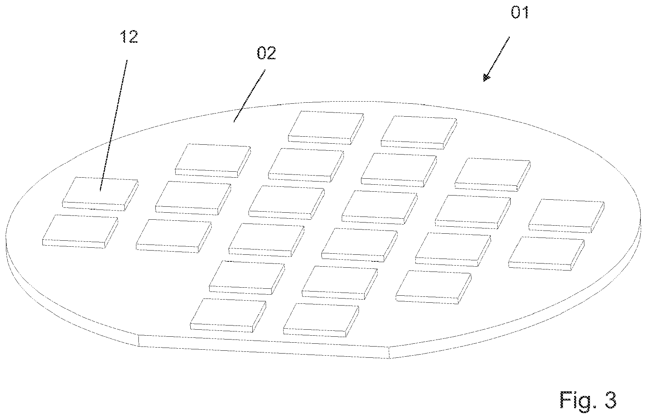

In Fig. 3 ist dargestellt, dass auf dem Silizium-Keramik-Verbundsubstrat 01 bei der Weiterprozessierung definierte Funktionsbereiche, hier Chips 12 in der Siliziumebene vereinzelt werden können. Dies kann durch Standard-Silizium-Ätzprozesse (z.B. reaktives Ionen-Ätzen - DRIE) erfolgen, wobei die Oberfläche der Niedertemperaturkeramik 02 als natürlicher Ätzstopp fungiert.

Die Standardtechnologien zur Vorbereitung und Verarbeitung der Niedertemperaturkeramik ermöglichen eine kostengünstige Integration elektrischer, fluidischer und optischer Schnittstellen zur Peripherie.

Zur Herstellung des erfindungsgemäßen Silizium-Keramik-Verbundsubstrates sind keine zusätzlichen Geräte, wie Chipbonder oder Bondvorrichtungen zum Anodischen Bonden, erforderlich. Es kann mit den ohnehin vorhandenen Vorrichtungen für die Standardverfahren der Halbleiter- und LTCC-Technologie hergestellt werden.

### Bezugszeichenliste

- 01: Silizium-Keramik-Verbundsubstrat
- 02: Niedertemperaturkeramik
- 03: Silizium-Substrat
- 04: Kontaktbereich
- 05: -
- 06: Nanostruktur
- 07: Laminieren
- 08: Sintern
- 09: Metallisierung
- 10: -
- 11: Via
- 12: Chip

## Patentansprüche

1. Halbleiterprozesskompatibles Silizium-Keramik-Verbundsubstrat (01), das die Form eines Standard-Wafers aufweist und kompatibel zu Anlagen und Geräten für eine sich anschließende Halbleiterprozessierung ist, umfassend
- eine keine natriumhaltigen Gläser enthaltende Niedertemperaturkeramik (02) mit mindestens einer vorstrukturierten Keramiklage und
- ein Silizium-Substrat (03), dessen Oberfläche in einem Kontaktbereich (04) zur Niedertemperaturkeramik (02) Nanostrukturen (06) aufweist, welche vollständig in die Niedertemperaturkeramik (02) eingedrungen sind,
wobei die Niedertemperaturkeramik (02) gleichzeitig eine Trägerschicht für das Silizium-Substrat bildet.

2. Silizium-Keramik-Verbundsubstrat (01) nach Anspruch 1, **dadurch gekennzeichnet, dass** die geometrischen Abmessungen der Nanostruktur (06) an die Pulvermorphologie der Niedertemperaturkeramik (02) angeglichen sind.

3. Silizium-Keramik-Verbundsubstrat (01) nach Anspruch 1 oder 2, **dadurch gekennzeichnet, dass** die Nanostrukturen (06) nadelförmig sind, und dass der Abstand zwischen den Nadeln der Korngröße der pulverförmigen Bestandtteile der Niedertemperaturkeramik (02) entspricht.

4. Silizium-Keramik-Verbundsubstrat (01) nach einem der Ansprüche 1 bis 3, **dadurch gekennzeichnet, dass** die Niedertemperaturkeramik (02) Vias (11), Leiterbahnen und/oder Fluidkanäle aufweist.

5. Silizium-Keramik-Verbundsubstrat (01) nach einem der Ansprüche 1 bis 4, **dadurch gekennzeichnet, dass** die Oberflächen der Nanostrukturen (06) vollständig oder teilweise eine Metallisierung (09) aufweisen.

6. Silizium-Keramik-Verbundsubstrat (01) nach Anspruch 5, **dadurch gekennzeichnet, dass** eine elektrische Verbindung zwischen der Metallisierung (09) des Silizim-Substrates (03) und den Leiterbahnen und/oder Vias (11) besteht.

7. Silizium-Keramik-Verbundsubstrat (01) nach einem der Ansprüche 1 bis 6, **dadurch gekennzeichnet, dass** das Silizium-Substrat (03) nur so dick ausgeführt ist, dass die in ihm zu realisierenden elektronischen Funktionen erzeugbar sind.

8. Silizium-Keramik-Verbundsubstrat (01) nach einem der Ansprüche 1 bis 7, **dadurch gekennzeichnet, dass** das Silizium-Substrat (03) eine Dicke von 50 bis 100 µm hat.

9. Verfahren zur Herstellung eines halbleiterprozesskompatiblen Silizium-Keramik-Verbundsubstrates (01), welches eine keine natriumhaltigen Gläser enthaltende Niedertemperaturkeramik (02) mit mindestens einer vorstrukturierten Keramiklage und ein Silizium-Substrat (03) besitzt, folgende Schritte umfassend:
- Strukturieren einer ungebrannten Keramikfolie;
- Erzeugen einer Trägerschicht aus einer oder mehreren Lagen der ungebrannten Keramikfolie;
- Erzeugen einer Nanostruktur auf einer Oberfläche eines Silizium-Substrats;
- Auflaminieren des Silizium-Substrates mit der nanostrukturierten Oberfläche auf die Trägerschicht unter Aufbringen von Druck und Temperatur und dabei vollständiges Einbringen der Nanostruktur in die Trägerschicht.

10. Verfahren nach Anspruch 9, **dadurch gekennzeichnet, dass** nachfolgend auf den Schritt des Auflaminierens ein Drucksinterprozess bei maximal 950°C durchgeführt wird.

11. Verfahren nach Anspruch 9 oder 10, **dadurch gekennzeichnet, dass** beim Strukturieren der Keramikfolie Leiterbahnen, Vias und/oder Fluidkanäle in bzw. auf dieser erzeugt werden.

12. Verfahren nach einem der Ansprüche 9 bis 11, **dadurch gekennzeichnet, dass** beim Strukturieren der Keramikfolie Widerstände, Kondensatoren und/oder Spulen in bzw. auf dieser erzeugt werden.

## Claims

1. A semiconductor process compatible silicon-ceramic composite substrate (01) which is in the form of a standard wafer and compatible with systems and devices for subsequent semiconductor processing, comprising
- a low temperature ceramic (02) containing glasses that contain no sodium, with at least one pre-structured ceramic layer and
- a silicon substrate (03), of which the surface in a contact region (04) with the low temperature ceramic (02) includes nanostructures (06) that have completely penetrated the low temperature ceramic (02),
wherein at the same time the low temperature ceramic (02) is a carrier layer for the silicon-ceramic substrate.

2. A silicon-ceramic composite substrate (01) according to claim 1, **characterized in that** the geometric dimensions of the nanostructure (06) are adjusted to the powder morphology of the low temperature ceramic (02).

3. The silicon-ceramic composite substrate (01) according to claim 1 or 2, **characterized in that** the nanostructures (06) are needle-shaped, and that the distance between the needles corresponds to the grain size of the powder-form components of the low temperature ceramic (02).

4. The silicon-ceramic composite substrate (01) according to any one of claims 1 to 3, **characterized in that** the low temperature ceramic (02) contains vias (11), conductor tracks and/or fluid channels.

5. The silicon-ceramic composite substrate (01) according to any one of claims 1 to 4, **characterized in that** all or part of the surfaces of the nanostructures (06) have a metallization (09).

6. The silicon-ceramic composite substrate (01) according to claim 5, **characterized in that** an electrical connection exists between the metallization (09) of the silicon substrate (03) and the conductor tracks and/or vias (11).

7. The silicon-ceramic composite substrate (01) according to any one of claims 1 to 6, **characterized in that** the silicon substrate (03) is only constructed thick enough to allow generation of the electronic functions that are to be carried out therein.

8. The silicon-ceramic composite substrate (01) according to any one of claims 1 to 7, **characterized in that** the silicon substrate (03) has a thickness of 50 to 100 µm.

9. A method for producing a semiconductor process compatible silicon-ceramic composite substrate (01) having a low temperature ceramic (02) that contains glasses which contain no sodium, with at least one pre-structured ceramic layer and a silicon substrate (03), comprising the following steps:
- structuring a green ceramic foil;
- generating a carrier layer from one or more layers of the green ceramic foil;
- generating a nanostructure on a surface of a silicon substrate;
- laminating the silicon substrate with the nanostructured surface onto the carrier layer with the application of pressure and temperature and at the same time introducing the nanostructure completely into the carrier layer.

10. The method according to claim 9, **characterized in that** a pressure sintering process at a maximum temperature of 950 °C is carried out after the laminating step.

11. The method according to claim 9 or 10, **characterized in that** during the patterning of ceramic foil conductor tracks, vias and/or fluid channels are created on the ceramic foil while it is being structured.

12. The method according to any one of claims 9 to 11, **characterized in that** resistors, capacitors and/or coils are created in and/or on the ceramic foil while it is being structured.

## Revendications

1. Substrat composite silicium-céramique compatible avec un traitement pour semi-conducteurs (01), lequel présente la forme d'une plaquette standard et est compatible avec des installations et appareils pour un traitement pour semi-conducteurs qui s'en suit, comprenant :
- une céramique basse température (02) ne contenant pas de verres à teneur en sodium avec au moins une couche en céramique pré-structurée, et
- un substrat de silicium (03) dont la surface présente des nanostructures (06) dans une zone de contact (04) avec la céramique basse température (02), lesquelles ont entièrement pénétré dans la céramique basse température (02),
dans lequel la céramique basse température (02) forme simultanément une couche de support pour le substrat de silicium.

2. Substrat composite silicium-céramique (01) selon la revendication 1, **caractérisé en ce que** les dimensions géométriques de la nanostructure (06) sont adaptées à la morphologie de poudre de la céramique basse température (02).

3. Substrat composite silicium-céramique (01) selon la revendication 1 ou 2, **caractérisé en ce que** les nanostructures (06) sont en forme d'aiguilles et que la distance entre les aiguilles correspond à la granulométrie des composants pulvérulents de la céramique basse température (02).

4. Substrat composite silicium-céramique (01) selon l'une des revendications 1 à 3, **caractérisé en ce que** la céramique basse température (02) présente des vias (11), des pistes conductrices et/ou des canaux de fluide.

5. Substrat composite silicium-céramique (01) selon l'une des revendications 1 à 4, **caractérisé en ce que** les surfaces des nanostructures (06) présentent, complètement ou partiellement, une métallisation (09).

6. Substrat composite silicium-céramique (01) selon la revendication 5, **caractérisé en ce qu'**il y a une connexion électrique entre la métallisation (09) du substrat de silicium (03) et les pistes conductrices et/ou vias (11).

7. Substrat composite silicium-céramique (01) selon l'une des revendications 1 à 6, **caractérisé en ce que** le substrat de silicium (03) est réalisé seulement avec une épaisseur telle, que des fonctions électroniques à réaliser dans celui-ci peuvent être produites.

8. Substrat composite silicium-céramique (01) selon l'une des revendications 1 à 7, **caractérisé en ce que** le substrat de silicium (03) est d'une épaisseur de 50 à 100 µm.

9. Procédé pour la fabrication d'un substrat composite silicium-céramique compatible avec un traitement pour semi-conducteurs (01), lequel possède une céramique basse température (02) ne contenant pas de verres à teneur en sodium avec au moins une couche en céramique pré-structurée et un substrat de silicium (03), comprenant les étapes suivantes :
- la structuration d'une feuille de céramique non cuite ;
- la production d'une couche de support à partir d'une ou plusieurs couches de la feuille de céramique non cuite ;
- la production d'une nanostructure sur une surface d'un substrat de silicium ;
- le laminage du substrat de silicium avec la surface nanostructurée sur la couche de support en appliquant une pression et une température et ce faisant, l'introduction complète de la nanostructure dans la couche de support.

10. Procédé selon la revendication 9, **caractérisé en ce que**, suite à l'étape de laminage, en exécute un processus de frittage sous pression à 950°C au maximum.

11. Procédé selon la revendication 9 ou 10, **caractérisé en ce que**, lors de la structuration de la feuille de céramique, on produit des pistes conductrices, des vias et/ou canaux de fluide dans ou sur celle-ci.

12. Procédé selon l'une des revendications 9 à 11, **caractérisé en ce que**, lors de la structuration de la feuille de céramique, on produit des résistances, des condensateurs et/ou des bobines dans ou sur celle-ci.
